# EUROPEAN PATENT APPLICATION

(11) **EP 2 093 703 A1**
(43) Date of publication of application: **26.08.2009**
(21) Application number: 07829368.5
(22) Date of filing: 05.10.2007
(51) Int. Cl.: G06K 19/077, G06K 19/07

(54) **LARGE-SIZE INLET MANUFACTURING METHOD, INLET-EQUIPPED TAPE, ITS MANUFACTURING METHOD, AND ITS MANUFACTURING DEVICE**

(30) Priority: 10.10.2006 JP 2006276964
(71) Applicant: SASAZAKI, Tatsuo, Urawa-Ku, Saitama-shi, Saitama 3300072 (JP)
(72) Inventor: SASAZAKI, Tatsuo, Urawa-Ku, Saitama-shi, Saitama 3300072 (JP)
(74) Representative: Skuhra, Udo
(86) International application number: PCT/JP2007/069630
(87) International publication number: WO 2008/044663

(57) **Abstract**

The present invention provides a method for manufacturing large-sized inlet arranged and attached inlets on a tape substrate accurately, reliably and in a low cost with improving productivity. Furthermore the present invention provides a method for manufacturing an inlet adhesive tape manufactured with the large-sized inlet, and an apparatus for manufacturing the inlet adhesive tape.

(Means for solving problems)

A method for manufacturing the large-sized inlet comprising: arranging an inlet element on an inlet substrate, unwound from inlet roll in column to have a predetermined pitch in a width direction of a inlet roll and in parallel to have a predetermined pitch in a longitudinal direction of a inlet roll, and cutting the tape substrate at every predetermined number of inlet elements arranged in parallel in a longitudinal direction of the inlet roll 1 on inlet roll where the inlet elements are arranged in column and parallel.

## Description

### BACKGROUND OF THE INVENTION

### Field of the Invention

The present invention relates to a method for manufacturing a large-sized inlet (large-unitized inlet), and an inlet adhesive tape and its manufacturing method. More specifically, the present invention relates to a method for manufacturing a large-sized inlet where a plurality of inlet elements are arranged in a row, and to slit an inlet adhesive tape and its manufacturing method. Herein, an inlet element includes IC chip and antenna mounted on an inlet substrate (film), and it functions as communication, calculation and memory use. Also, an inlet includes the inlet substrate and the inlet element, and a large-sized inlet includes a large-sized substrate and a plurality of the inlet elements. Please note that the inlet has the antenna included in an IC chip, but this invention also includes the inlet having the antenna formed outside the IC chip via printing or etching process.

### Description of the Background Art

A technique for attaching an inlet in its processing step is now proposed, wherein the inlet works as an IC tag recording and reading a digital information such as a manufacturer name, a manufacturer's serial number on a processed-cardboard for a packaging container, a plastic film, a processed-plastic film, and processed-sheet materials such as paper board.

And, designing IC tag circuit mounted on IC chip, a method for processing a wireless radio wave, and standardizing others have been invented rapidly, wherein the IC tag is attached on a respective goods for their distribution and selling.

Furthermore, it is considered that costs for hardware such as an IC chip, a radio wave for an antenna, a reader, and a writer etc... has been progressively saved. In the present invention, IC includes an IC formed on an IC chip or a print.

In the situation, it is required that a method for attaching the inlet on a packing material and other distribution can be achieved in a low cost and a high reliability. In addition, it is also required that a method for attaching it on various materials can be achieved without any trouble for a long time.

Now, the inlet with an adhesive material can be handled mechanically, and be remade into its large size so that it can attach tenaciously on an outside of the distribution box and goods respectively.

As the inlet is widely used in a near future, new methods have been required for producing the inlet in low cost materials, and for attaching the inlet automatically in a processing or packaging of a sheet without dropping. Furthermore, the new methods have been also required for tenaciously attaching the inlet in a low cost without any frictionally-induced damages.

In Japan, Europe and America, reviewing a cardboard box representative for a container for attaching an inlet, a labeler attaches a labeled-inlet sized comparatively larger than an inlet after packing a goods in a cardboard box.

The defective rate for labeling is higher than 10%, but it is not acknowledged as a problem as the inlets are now labeled on goods in a trial basis. However, in a near future, the inlet will be attached on all of the distribution box, and sales promotion goods. Furthermore, the inlet will also be attached on medical goods. Now, the exfoliate paper is used for labeling the inlet, which may increase the cost for its labeling.

In a Patent document 1, an inlet including IC chips and antennas on a film substrate is disclosed. The inlet is aligned on an adhesive tape substrate at a predetermined pitch identical to the sheet cut pitch. It should be noted that the adhesive tape material excels in its tension strength, and the inlet is provided in the form of tape. In the publication, the inlet adhesive tape is prepared for labeling the inlet on a predetermined pitch in a packaging sheet at a normal speed or in a high speed, and for providing only the tenacious inlet labeling in a packaging line.

The inlet adhesive tape is attached on an elongate adhesive tape at a predetermined pitch in a width direction of the elongate tape (narrow side). For manufacturing the inlet tape, an inlet roll, on which the inlet element is arranged, is utilized very well, so that the film width corresponds to the wide side of the rectangle inlet.

However, it is difficult to manufacture the inlet tape by cutting the inlet element from the inlet roll, and by attaching and arranging the inlet element on the elongate tape substrate width substantially identical to the inlet width (narrow side). The inlet size varies depending on the radio wave types. Especially, it is very difficult to attach and arrange the ultracompact inlet (about 0.4 mm squared) and the compact inlet (about 1∼2 mm*60∼70mm) on the tape material. Even if it is manufactured, productive rate is very low.

It is essential to have a high-precision mounting device (inlet transfer device) for quickly and exactly arranging the inlet cut out from the inlet roll on the tape width without any misalignment, even though the inlet is not compact. When the high-precision mounting device is equipped, the apparatus will be enlarged and very expensive. Therefore, it may cause difficulty in manufacturing the inlet adhesive tape for the packaging container in a low price.

When the high-precision mounting device can not be used, it is necessary to prepare an extra pitch in a tape for the misalignment in order to prevent the inlet from protruding. Furthermore, it is necessary to increase the tape width that is a wider than an inlet width. As a result, the material cost will be increased.

Now, the conventional compact IC tag includes an exterior antenna for the inlet. The exterior antenna size is about 1.5 mm in width and about 65mm in length, and is pitched about 1mm from an antenna next to the exterior antenna, and the antenna arranged on the inlet substrate. An inlet is divided into the slit in order to set the exterior antenna in a paper card layer. Since the slit inlet is too compact for the mechanical handling, the IC tag and the antenna are sandwiched between a film in the inlet substrate and the laminated film in order to prepare a large member with about 9mm in width and about 70mm in length. Furthermore, a larger label is applied in order to attach the inlet on the goods surface tenaciously. It is required to prepare the inlet in its small size, not in a large size.

Patent document 1: Japanese laid-open publication Tokkai 2005-310137

### DISCLOSURE OF INVENTION

### PROBLEMS OF THE INVENTION AIMS TO SOLVE

In order to overcome these problems in the prior art described above, the present invention provides a method for manufacturing the large-sized inlet arranged and attached the inlets on a tape substrate accurately, reliably and in a low cost with improving productivity. Furthermore the present invention provides a method for manufacturing an inlet adhesive tape manufactured with the large-sized inlet, and an apparatus for manufacturing the inlet adhesive tape.

### MEANS TO SOLVE PROBLEMS

The present invention described in Claim 1 relates to a method for manufacturing the large-sized inlet, comprising arranging an inlet element on an inlet substrate, unwound from an inlet roll in column to have a predetermined pitch in a width direction of an inlet roll and in parallel to have a predetermined pitch in a longitudinal direction of an inlet roll, and cutting the tape substrate at every predetermined number of the inlet elements aligned in parallel in a longitudinal direction of the inlet roll 1 on the inlet roll where the inlet elements are aligned in column and parallel.

The present invention described in Claim 2 relates to the method for manufacturing the large-sized inlet according to Claim 1, comprising slitting up the pitch between the inlet elements from the edge of an inlet roll which aligns the an inlet element in a width direction of the inlet roll after arranging inlet elements in column and parallel on the inlet substrate and, wherein in the process for manufacturing the large-sized inlet, the slit inlet roll is cut at every predetermined number of the inlet elements aligned in parallel in a longitudinal direction of the inlet roll in the process for manufacturing the large-sized inlet.

The present invention described in Claim 3 relates to the method for manufacturing the large-sized inlet according to Claim 1 or Claim 2, comprising boring a hole between the inlet elements in a longitudinal direction of the inlet roll after arranging the inlet elements in column and parallel on the inlet substrate.

The present invention described in Claim 4 relates to the method for manufacturing the large-sized inlet according to Claim 1 or Claim 2, wherein the adhesive substrate is preliminary coated on the back side of the inlet roll where the inlet element is not aligned, before arranging the inlet elements.

The present invention described in Claim 5 relates to the method for manufacturing the large-sized inlet according to Claim 1 or Claim 2, wherein in the step of arranging, the inlet elements are aligned to have zero interval as a predetermined pitch in parallel in a longitudinal direction of the inlet roll, the inlet roll width, or both directions in the process of arranging.

The present invention described in Claim 6 relates to an inlet adhesive tape On an adhesive face of tape-based substrate, manufactured through a step of attaching a large-sized inlet which is formed to have a plurality of the inlet elements aligned in a row on the inlet substrate, wherein the large-sized inlet is attached on the tape-based substrate to have a predetermined pitch in a width direction of the inlet-based substrate corresponding to the direction of arranging the inlet elements in a row, wherein the large-sized inlet is slit to go through a pitch between a plurality of the inlet elements in a longitudinal direction of the tape-based substrate, wherein the tape-based substrate with the large-sized inlets is slit in a longitudinal direction of the tape-based substrate, wherein the inlet is aligned in a row to have a predetermined pitch on each slit tape-based substrate.

The present invention described in Claim 7 relates to the inlet adhesive tape according to Claim 6, wherein an adhesive substrate on the other face of the adhesive substrate has a higher melting point than that on the adhesive face.

The present invention described in Claim 8 relates to the inlet adhesive tape according to Claim 6 or Claim 7, wherein a plurality of the inlet elements is arranged adjacently on the large-sized inlet.

The present invention described in Claim 9 relates to wherein in the step of attaching the large-sized inlet on the tape based substrate and attaching the inlet adhesive tape on a sheet, the adhesive substrate is coated on the exposed face of the large-sized inlet.

The present invention described in Claim 10 relates to the inlet adhesive tape according to Claim 6 or Claim 7, wherein the adhesive substrate is preliminarily coated on the back side of the large-sized inlet where the inlet elements are not arranged, wherein the front side of the large-sized inlet is attached on the tape-based substrate, wherein the adhesive substrate on the back side thereof melts by heating when the inlet adhesive tape is attached to goods.

The present invention described in Claim 11 relates to the inlet adhesive tape according to Claim 6 or Claim 7, wherein the inlet substrate has notch portion on at least one face of the slit inlet around the inlets attached on the tape-based substrate.

The present invention described in Claim 12 relates to the inlet adhesive tape according to Claim 6 or Claim 9, wherein the inlet element mounted on the inlet substrate, is arranged between the adhesive face of the tape-based substrate and the inlet substrate.

The present invention described in Claim 13 relates to the inlet adhesive tape according to Claim 6 or Claim 7, wherein the tape-based substrate is cut on both edges of the inlets in a longitudinal direction of the tape-based substrate when the tape-based substrate and the large-sized inlet are slit in a longitudinal direction of the tape-based substrate.

The present invention described in Claim 14 relates to a method for manufacturing the inlet adhesive tape, comprising providing the tape-based substrate by providing the tape-base substrate from a reel winding the tape-based substrate of which adhesive substrate is coated on one face, arranging a large-sized inlet where a plurality of the inlet elements are aligned in a row, on the adhesive face thereof to have a predetermined pitch in a width direction of tape-based substrate corresponding to the direction of arranging the inlet elements in a row, slitting the tape-based substrate with the large-sized inlet to go through the pitch between a plurality of the inlet elements arranged on the large-sized inlet in a row, winding each inlet adhesive tapes aligned in a row separately to have a predetermined pitch after slitting.

The present invention described in Claim 15 relates to a method for manufacturing the inlet adhesive tape according to Claim 14, comprising coating adhesive substrate which has a higher melting point than that on the adhesive face, on the other face (the second adhesive face) of the adhesive face of the tape-based material before providing the tape-based substrate.

The present invention described in Claim 16 relates to a method for manufacturing the inlet adhesive tape according to Claim 14 or Claim 15 further comprising coating the adhesive on the exposed face of the large-sized inlet after arranging the large-sized inlet.

The present invention described in Claim 17 relates to a method for manufacturing the inlet adhesive tape according to Claim 14 or Claim 15, wherein the adhesive substrate is preliminarily coated on the back side of the large-sized inlet, on which the inlet elements are not arranged.

The present invention described in Claim 18 relates to a method for manufacturing the inlet adhesive tape according to Claim 14 or Claim 15, wherein in the step of slitting, the inlet adhesive tape is slit on both edges of the inlets in a longitudinal direction of the tape-based substrate, so that the extra pitch of the tape-based substrate is removed.

The present invention described in Claim 19 relates to an apparatus for manufacturing the inlet adhesive tape arranging the inlets on the adhesive face of tape-based substrate, comprising, a tape-based substrate reel winding the tape-based substrate where an adhesive substrate is coated on one face thereof, a magazine where the large-sized inlets arranging a plurality of the inlet elements in a row are loaded and retrieving the large-sized inlet from an aperture of it, a pick-up member opposed to the aperture which the tape-based substrate goes through between them, and wherein the tape based substrate is provided by unwinding the tape-based material wound on the reel or halted the process temporarily, a slitter for slitting the large-sized inlet to have the pitch between the inlet elements arranged on the tape-based substrate in a row, a plurality of reels for winding each inlet adhesive tapes separately on which the inlets slit by the slitter are arranged to have a predetermined pitch in a row, wherein the adhesive face of the tape-based substrate is pressed against the large-sized inlet on which the aperture is arranged when at least one of the magazine or the pick-up member approaches toward the other, and then, the large-sized inlet including the aperture is unwound from the magazine when at least one of the magazine or the pick-up member gets away from the other.

The present invention described in Claim 20 relates to an apparatus for manufacturing the inlet adhesive tape according to Claim 19, wherein an adhesive substrate on the other face of the adhesive face has a higher melting point than that on the adhesive face.

The present invention described in Claim 21 relates to an apparatus for manufacturing the inlet adhesive tape according to Claim 19 or Claim 20, wherein the pick-up member includes an arm and a roll having reciprocating motion, and is arranged opposed to the aperture and is arranged in the upper stream and the lower stream of the tape based substrate placed between the pick-up member and the aperture along the direction of providing tape-based substrate, wherein a bar for unwinding large-sized inlet is arranged on the adhesive face of the tape-based material, and follows the direction where the pick-up member displaces, so that the tape substrate is withdrawn from the aperture.

The present invention described in Claim 22 relates to an apparatus for manufacturing the inlet adhesive tape according to Claim 19 or Claim 20, wherein a bar for the pick-up member arranges to the non-adhesive face side of the tape-based substrate and is arranged opposed to the aperture and is arranged in the upper stream and the lower stream of the tape based substrate placed between the pick-up member and the aperture along the direction of providing tape-based substrate, wherein the bar for the pick-up member arranges to the other face of the adhesive face of the tape-based substrate and catch the tape-based material as the tape-based material is pressed down by suction of the pick-up member.

### EFFECT OF THE INVENTION

According to the present invention described in Claim 1, a method for manufacturing the large-sized inlet arranges the inlet elements on the inlet substrates at a predetermined pitch in column and parallel, and slits the inlet substrate at every predetermined number of the inlet elements aligned in parallel in a width direction of each inlet roll, so that compact and user-friendly a large-sized inlet may be manufactured without handling a prior small inlet and arranged and attached accurately and reliably on a tape-based material with improving productivity.

According to the present invention described in Claim 2, a method for manufacturing the large-sized inlet arranges the inlet elements on the inlet substrates at a predetermined pitch in column and parallel, slits the pitch between the inlet elements in a width direction of the inlet roll, and cuts the inlet substrate at every predetermined number of the inlet elements aligned in parallel in a longitudinal direction of each slit inlet roll, so that compact and user-friendly the large-sized inlet may be manufactured without handling a prior small inlet and arranged and attached accurately and reliably on a tape-based material with improving productivity.

According to the present invention described in Claim 3, a method for manufacturing the large inlet punches between the inlet elements in a longitudinal direction of the inlet roll after aligning the inlet element in column and parallel on the inlet substrate, so that the inlet is covered between the tape-based substrate and goods, and is strongly protected in spite of extremely-thin inlet substrate (about 0.15mm) by attaching at the adhesive portion of the four sides around the inlet when the inlet adhesive tape having exposed portion of adhesive substrate around the inlet arranged on a tape-based substrate, is attached to goods such as case etc... as the inlet adhesive tape is manufactured with the large-sized inlet, on which the inlet elements arranged and attached.

According to the present invention described in Claim 4, before arranging the inlet elements, adhesive substrate is preliminary coated on the back side of an inlet roll, the large-sized inlet attached on tape-based substrate as the inlet elements is arranged on the face of tape-based substrate, and an inlet adhesive tape is manufactured by slitting the large-sized inlet adhesive tape manufactured above, so that the inlet adhesive tape may be strongly attached on sheet substrates by adhesive substrate on a portion of the inlet when it is attached on sheet substrates.

According to the present invention described in Claim 5, on the step of arranging the inlet elements, the inlet elements are aligned in parallel at a predetermined pitch, which is zero, in a longitudinal direction of the inlet roll, so that a inlet adhesive tape of minimal width without extra pitch can be manufactured if the large-sized inlet adhesive tape, manufactured by attaching the large-sized inlet on the tape-based substrate, is slit between the inlet elements.

According to the present invention described in Claim 6, a large-sized inlet, on which a plurality of the inlet elements are aligned in a row, is applied on tape-based substrate in a width direction of the tape-based substrate corresponding to the direction of arranging the inlet elements in a row, the tape-based substrate is slit between the inlet elements in a longitudinal direction of the tape-based material, and an inlet adhesive tape consists of arranging the inlets in a row on the tape-based substrate, hence both side of cross sectional surface of the slit tape-based substrate and both side of the inlets in a longitudinal direction of tape-based substrate completely match and form respectively flat surface, so that the inlet adhesive tape can be directly attached to goods, such as case etc..., if the inlet adhesive tape is cut on a tape substrate at a predetermined pitch.

According to the present invention described in Claim 7, adhesive substrate on the other face of the adhesive face has a higher melting point than that on the adhesive face, so that only adhesive face attaching a large-sized inlet can be turned into moderate condition of adhesion by leading a tape-based substrate to constant-temperature reservoir etc., set at low melting point of adhesive substrate, when the large-sized inlet is attached on tape-based substrate by unwinding tape-based substrate, or both adhesive faces of tape-based substrate can be turned into moderate condition of adhesion by setting constant-temperature reservoir at high melting point of adhesive substrate in order to attach an inlet adhesive tape between two sheets etc....

According to the present invention described in Claim 8, pluralities of the inlet elements are arranged adjacently, so that an inlet adhesive tape of minimal without extra pitch width can be manufactured.

According to the present invention described in Claim 9, adhesive substrate is coated on exposed face of the large-sized inlet as the large-sized inlet is attached on the tape-based substrate or the inlet adhesive tape is attached on a sheet, so that the inlet adhesive tape is strongly attached on sheet substrate by adhesive substrate on the inlet portion and can be manufactured as the inlet adhesive tape is attached on sheet substrate.

According to the present invention described in Claim 10, the large-sized inlet is preliminary coated adhesive substrate on the back side of it and the front side of the large-sized inlet is attached on tape-based substrate, and an adhesive face is melt by heating for attaching an inlet adhesive tape on the goods, so that it is not necessarily to coat adhesive substrate to the inlet elements of the large-sized inlet or each small inlets, the inlet adhesive tape can be attached to goods by only heating, furthermore front side of the inlet adhesive tape, where the inlet elements are arranged, is attached on tape-based substrate, and the inlet adhesive tape, protected the inlet portion, can be provided.

According to the present invention described in Claim 11, the inlet substrate has notch on at least one side to the directions of the inlet length and the tape substrate length around the inlet which is attached on the tape-based substrate, so that the inlet is covered between the tape-based substrate and goods, and is strongly protected by attaching at the adhesive portion of the four sides around the inlet when the inlet adhesive tapes having exposed portion of adhesive substrate around the inlet, arranged on a tape-based substrate and applied and manufactured with the large-sized inlet, is applied to goods such as case etc..

According to the present invention described in Claim 12, the inlet substrate, where antennas and IC chips are mounted, is arranged between adhesive face of the tape-based material and the inlet substrate, so that they can be protected strongly and efficiently by minimal member.

According to the present invention described in Claim 13, the tape-based material is cut on both edges of the inlet along its length when the tape-based substrate with the large-sized inlet is slit along its length, so that an inlet adhesive tape without extra pitch can be manufactured.

According to the present invention described in Claim 14, a large-sized inlet, on which a plurality of inlet elements is aligned in a row, is arranged on adhesive face of the tape-based substrate at a predetermined pitch in a width direction of tape-based substrate corresponding to the direction of arranging the inlet elements in a row, and the tape-based substrate is slit separately between a plurality of the inlet elements, attached at a predetermined pitch on adhesive face of tape-based substrate, so that the inlet can be handled easily, production costs of the inlet be brought down by saving the extra pitch around the inlet, and the productivity can be improved.

According to the present invention described in Claim 15, the adhesive substrate, coated on the other face (the second adhesive face) of the one face of the tape-based substrate, have a higher melting point than that on the adhesive face, so that only adhesive face attaching the large-sized inlet can be turned into moderate condition of adhesion by leading the tape-based substrate to constant-temperature reservoir etc., set at low melting point of adhesive substrate, when the large-seized inlet is attached on tape-based substrate provided by unwinding tape-based substrate, or both adhesive faces of tape-based substrate can be turned into moderate condition of adhesion by setting constant-temperature reservoir at high melting point of adhesive substrate in order to attach the inlet adhesive tape between two sheets etc....

According to the present invention described in Claim 16, adhesive substrate is coated on the exposed face of the large-sized inlet after arranging the large-sized inlet so that the inlet adhesive tape, strongly attaches on a sheet substrate by adhesive substrate on the inlet portion when the inlet adhesive tape is attached on sheet substrate, can be manufactured.

According to the present invention described in Claim 17, adhesive substrate is preliminary coated on the large-sized inlet, so that the inlet adhesive tape, strongly attached on sheet substrate by adhesive substrate on the inlet portion when the inlet adhesive tape is attached on sheet substrate.

According to the present invention described in Claim 18, wherein the inlet adhesive tape slit on both edges of the inlets in a longitudinal direction of the tape-based substrate on the step of slitting tape-based material and removing excess tape-based material, so that minimal width of the inlet adhesive tape without extra pitch can be manufactured.

According to the present invention described in Claim 19, an apparatus for manufacturing the inlet adhesive tape includes a magazine having an aperture, where the large-sized inlets are loaded, a pick-up member arranged opposed to the aperture and the tape-based substrate is slipped between a pick-up member and the aperture, and the slitter, which slit the pitch between the inlet elements in a longitudinal direction of tape based substrate. The side face of the tape-based material is pressed against the large-sized inlet on which the aperture is arranged when the magazine or the pick-up member approaches toward the other, and then, the large-sized inlet including the aperture is unwound from the magazine when the magazine or the pick-up member gets away from the other, so that the inlets can be arranged and attached accurately and reliably on tape-based substrate provided by adhesion effect of adhesive substrate, or on tape-based substrate at rest with maintaining the productivity, and the inlet adhesive tape may be manufactured in a low cost by simple structure of a magazine and pick-up members. Furthermore after the large-sized inlet, arranged a plurality of the inlets, attached on the tape-based substrate, the tape-based substrate is slit, and the inlet adhesive tape, on which each inlets attached at a predetermined pitch in a row, is manufactured, so that the inlet can be easily handled, the production costs of the inlet can be brought down by saving the extra pitch around the inlet and the productivity may be improved.

According to the present invention described in Claim 20, adhesive substrate on the other face of the adhesive face has a higher melting point than that on the adhesive face, so that only adhesive face attaching a large-sized inlet may be turned into moderate condition of adhesion by leading the tape-based substrate to constant-temperature reservoir etc..., set at low melting point of adhesive substrate, when the large-sized inlet is attached on tape-based substrate provided by unwinding tape-based substrate, or both adhesive faces of tape-based substrate may be turned into moderate condition of adhesion by setting constant-temperature reservoir at high melting point of adhesive substrate.

According to the present invention described in Claim 21, the pick-up member includes an arm and a roll having reciprocating motion, and is arranged in the upper stream and lower stream of the area between the pick-up member and the aperture (the pick-up member is opposed to the aperture) to the direction of providing tape-based substrate, a bar for unwinding the large-sized inlet, arranged to the adhesive face of the tape-based substrate, is displaced along the same direction as the pick-up member is displaced, and the large-sized inlets, attached on the tape-based substrate, can be withdrawn quickly from the magazine, and the large-sized inlet, arranged on the tape-based substrate by adhesion effect of adhesive substrate on the tape-based substrate, may be withdrawn surely from a aperture of the magazine while providing tape-based material. Furthermore, the bar for unwinding a large-sized inlet consists of a simple configuration compared to configuration of using air compressor, and an inlet adhesive tape may be manufactured under simple configuration.

According to the present invention described in Claim 22, the pick-up member having reciprocating motion by suction function and is arranged in the upper stream and lower stream of the area between the pick-up member and the aperture (the pick-up member is opposed to the aperture) to the direction of providing the tape-based substrate, and a bar for unwinding pick-up member, arranged to the adhesive face of the tape-based substrate, catches the tape-based substrate as the tape-based substrate is pressed down by suction and displacement of the pick-up member, so that tape-based substrate returns in the position of the bar for unwinding pick-up member and may be withdrawn quickly from pick-up member while providing tape-based substrate.

### DESCRIPTION OF THE PREFERRED EMBODIMENTS

Hereunder, a method for manufacturing a large-sized inlet and an inlet adhesive tape, and an apparatus for manufacturing the inlet adhesive tape according to the present invention will be described with reference to the accompanying drawings.

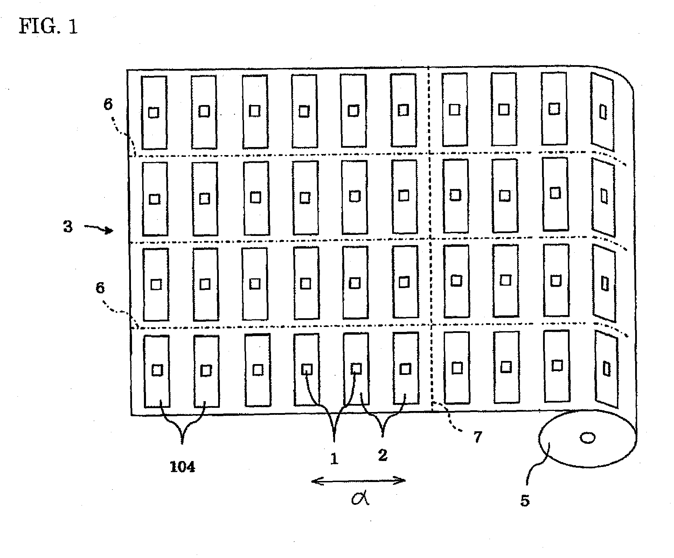

Fig.1 shows a schematic view illustrating one example of an inlet roll used in the method for manufacturing the large-sized inlet according to the present invention.

Fig.1 shows that the inlet element (104) at least consisting of an IC chip (1) and an antenna (2), is mounted on an inlet substrate (3) slightly unwound from wound-inlet roll (5). Also, in the drawing, rectangle illustrated as an inlet element (104), corresponds to the shape of the antenna (2), and an inlet comprises the inlet element (104) and the inlet substrate (3).

A plurality of inlets (4) is arranged on the inlet roll (5) in column at a predetermined pitch in a width direction of the inlet roll (5). A plurality of inlets (4) is arranged on the inlet roll (5) in parallel at a predetermined pitch in a longitudinal direction of the inlet roll (5) (a).

An inlet roll (5) is cut at a slitting-plane line (6) and cutting-plane line (7), and a large-sized inlet is shown in the area of inlet substrate consisting of the predetermined number of the inlet elements (104). For example, Fig.1 shows 6 rows of the inlet elements (104) in a large-sized inlet. So, a large-sized inlet is configured to arrange a plurality of the inlet elements on the inlet substrate in a row at a predetermined pitch. The number of the inlet elements on a large-sized inlet can be set depending on the volume of production lot, the slitter performance for the slitting inlet substrate, and the rigidity of the inlet substrate used by an apparatus for manufacturing the large-sized inlet etc....

As used herein, the term "predetermined pitch" may change in accordance with certain rules. Therefore, the inlets, having thickness, may be easily accumulated in stable state without concentrating on a certain part of a sheet, which may reduce to load on a certain part of an inlet. Furthermore, an inlet may be utilized for identifying a sheet or a card on which the inlet is attached, by an apparatus for detecting the inlet.

An inlet element (104) is not limited to rectangle as described above and may be in various shapes such as square, oval figure. When the shape of inlet elements (104) is square, the inlet element (104) width and length are the same lengths. Or, when the shape of the inlet elements (104) is rectangle, an inlet roll (5) width may correspond to an inlet element (104) width without being limited to corresponding to an inlet element (104) length as described above. So, inlet elements (104) may be arranged on the inlet substrate (3) like roll, regardless of the direction of the inlet element (104) width and length.

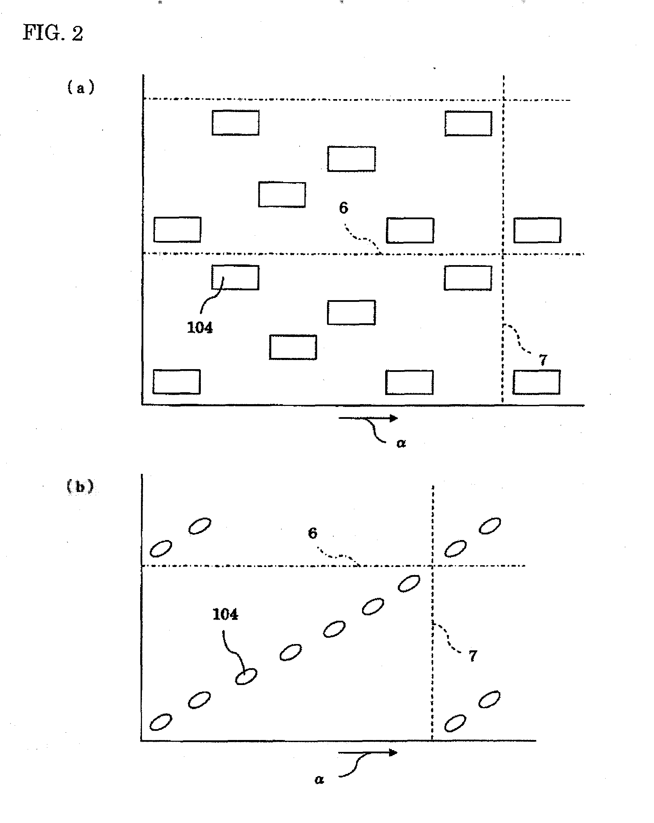

According to the present invention, as the direction of inlets arranged on the inlet substrate is not determined, the inlet including its arrangement can be arbitrarily set up. For example, in the area of the inlet substrate (3) on which a large-sized inlet is formed, the inlet elements (104) may be arranged on an inlet substrate (3) zigzag (Fig.2 (a)) and diagonally (Fig.2 (b)) on an inlet substrate. Although the inlet elements (104) are arranged in random order, it means that the inlet elements (104) are arranged in a row unless a plurality of the inlet elements (104) is piled up in a longitudinal direction of the inlet roll (5) (α). As described above, it matches the definition of a large-sized inlet.
And as zigzag arrangement such as Fig 2 (a), a transfer device enable to arrange the inlet elements (104) efficiently, when the adjacent the inlet elements (104) are arranged respectively as far as possible in a width direction of roll of the inlet substrate (3) in the large-sized inlet. Accordingly, the inlet elements (104) may be arranged at the same time in several rows, as the sufficient pitch is set between the inlet elements (104) in a longitudinal direction of the inlet substrate (α) when the inlet elements (104) are arranged in a longitudinal direction of the inlet substrate(α)from an edge of the inlet substrate like (3) roll.

The above example shows that the long sides of the inlet elements (104) are arranged on the inlet substrate (film) (3) in its width direction. In the present invention, arranging the inlet elements (104) in column means arranging the inlet elements in a width direction of the inlet substrate (3) like roll. Arranging the inlet elements (104) in parallel means arranging the inlet elements in a longitudinal direction of the inlet substrate like roll.

The large-sized inlets are divided in two classes in their manufacturing method. In the first manufacturing method, a large-sized inlet is manufactured from an inlet roll (5) consisting of a plurality of the inlet elements (104) arranged on the inlet roll in parallel at a predetermined pitch. In the second manufacturing method, the large-sized inlet is manufactured as below:
arranging a plurality of the inlet elements (104) on an inlet roll (5) in column and parallel at a predetermined pitch: and
punching the pitch between the inlet elements (104) arranged in parallel.

The first method for manufacturing a large-sized inlet can be more specifically explained. The step 1 for the first method comprising: unwinding an inlet substrate (3) like roll from an inlet roll (3), arranging inlet elements (104) in column at a predetermined pitch, so that the length of the inlet elements (104) corresponds to the width of the inlet substrate (3) on the edge portion of the inlet substrate (3).
The step 2 for the first method comprising: arranging the inlet elements (104) in parallel and column in a narrow pitch about 1∼3mm in a longitudinal direction of an inlet substrate. Due to designed condition of an inlet adhesive tape, pitch between the inlet elements (104) may be set wider than about 1∼3mm.

The step 3 for the first method comprising: slitting an inlet substrate (3) from an edge of an inlet roll (5) along a plurality of slitting-plane lines (6) by a slitter after inlet elements (104) are arranged, and winding each of the slit-inlet roll (5) from the edge of the inlet roll (5). For an instance, the slitter has ring-shaped blades whose number corresponds to that of the slitting-plane lines.
In this condition, the inlet elements (104) are arranged in a row on each inlet roll (5). Or, Inlet substrates (3) are wounded on each inlet roll (5), so that the inlet elements (104) may be safely handled on an inlet substrate (3). In addition, on the step 3 described above, the next step may start without winding each inlet rolls after slitting an inlet roll on step3.

The step 4 for the first method comprising: unwinding a wound inlet roll (5) to three-way guide frame, and cutting the inlet roll including six inlet elements (104) along cutting-plane lines (7) as shown Fig.1, so that a large-sized inlet is manufactured.
In this case, an inlet roll may be punched around a plurality of inlets (4) instead of cutting along cutting-plane lines (7). As it may be punched in this way, it is not necessarily that an inlet roll (5) is slit along all slitting-plane lines (6) and the inlet elements (104) are arranged in a row on an inlet roll (5), because, a large-sized inlet may be manufactured by punching an inlet roll even if inlet elements (104) are arranged in two or three rows on an inlet roll (5). Similarly, it is also possible to skip the step 3 for slitting an inlet roll (5) and to cut a non-slit inlet roll to manufacture a large-sized inlet by punching an inlet roll (5).

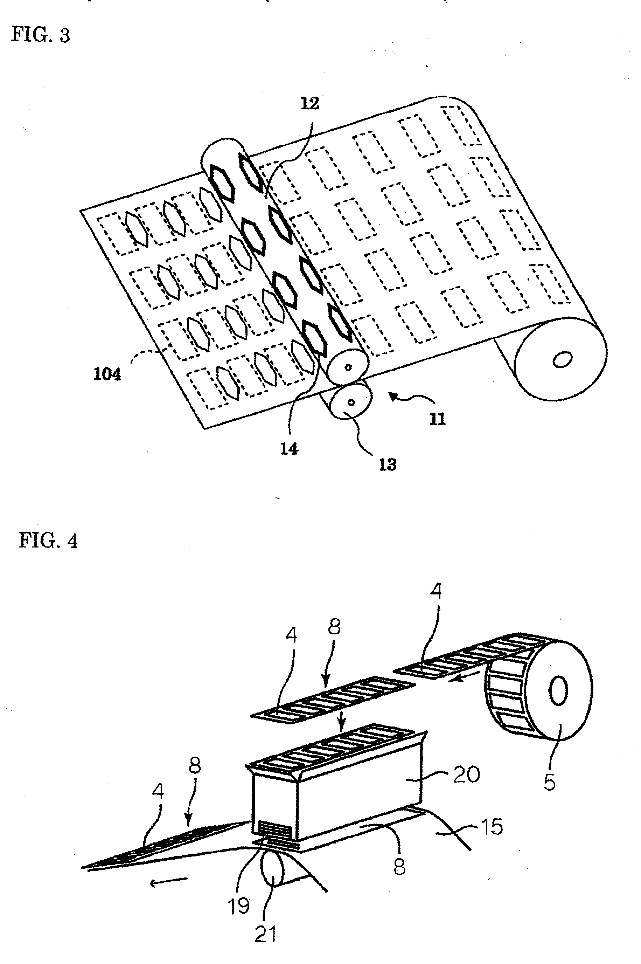

Referring to Fig.1 and Fig.3 more specifically, the second method for manufacturing a large-sized inlet are shown as below.
Fig.3 illustrates that an inlet roll is punched on the pitch between the inlet elements using an apparatus for punching a film. An inlet roll (5) goes through between an upper rotary (12) having a mold (14) and a lower rotary (13) of a rotary-type apparatus for punching a film (11). The sharpen projection is formed on the mold (14) and the rest of which is cut by the method of electric discharging on a metal surface of an upper rotary (12), so that the blades are prepared.

First, as described on the first method, the step 11 for the second method comprising: unwinding a wound inlet roll (5), and arranging the inlet elements (104) in column at a predetermined pitch so that the length of the inlet elements (104) corresponds to the width of the inlet substrate (3) on the edge portion of the inlet substrate (3).
The step 12 for the second method comprising: arranging each inlet element (104) on the inlet substrate (3) in parallel in a wide pitch about 5∼50mm along its length so that the inlet elements (104) arranged in column.
The step 13 for the second method comprising: arranging the inlet elements (104) in parallel in a longitudinal direction of an inlet roll and boring holes at the pitch between the inlet elements (104) on an edge of an inlet roll (5) using a rotary-type apparatus for punching a film as shown Fig.3. For instance, the holes are formed in polygonal shape, such as hexagonal shape like Fig.3, in order to have the same size of an inlet element (104).

As described on the first method, the step 14 for the second method comprising: winding each of the slit-inlet roll (5) from the edge of the inlet roll (5), while slitting an inlet substrate (3) from an edge of punched inlet roll (5) along a plurality of slitting-plane lines (6) by a slitter.
As described on the first method, the step 15 for the second method comprising: cutting a wound inlet roll (5) including a plurality of the inlet elements (104) along cutting-plane lines or punching around the plurality of the inlet elements (104), so that a large-sized inlet having holes is manufactured. The purpose of the step for boring a hole will be described below.
Owing to the step, boring a hole and manufacturing a large-sized inlet may be carried out at the same time.

A large-sized inlet adhesive tape is manufactured with the large-sized inlets made by the first method or the second method, and an inlet adhesive tape which includes the inlets arranged in a row is manufactured with a large-sized inlet adhesive tape.
According to the present invention, an adhesive substrate is coated on an inlet adhesive tape. For manufacturing the inlet adhesive tape, the various apparatuses include rollers etc..., which wind silicon rubber etc... with mold reliability. Because, the adhesive substrate has bad influence due to the apparatus movement for manufacturing the inlet adhesive tape by the adhesion of the adhesive substrate. According to the present invention, the adhesive substrate includes adhesion for attaching a large-sized inlet on the tape substrate. At normal temperature the adhesive substrate is dry. The adhesive substrate includes hot-melt adhesive which includes adherence when the coating layer of adhesive is heated in the step of transferring the large-sized inlet on the wide width tape substrate. Accordingly, it is required to heat the adhesive tape in order to increase its adherence when a sheet is attached on the inlet adhesive tape manufactured by slitting tape-based material having the hot-melt adhesive.

First, describing the usage of a large-sized inlet manufactured by the first method, the step 21 comprising: unwinding a tape-based material (15) wound in a tape-reel, and providing the tape-based material.
The step 22 comprising: on the adhesive face of wide width tape-based material (15), transferring each large-sized inlet (8) manufactured by cutting or punching an inlet roll (5) as described in the step 4. For instance, a large-sized inlet is transferred by a transfer device having a plurality of robotic arms having a small vacuum cup on the edge thereof. The adhesive may include general-purpose adhesive such as acrylic and rubber adhesive. The release agent is preliminary treated on the surface of the tape-based material (15), which may also be achieved inline after the adhesive may be coated inline after the tape substrate is provided by unwinding untreated tape from tape-based roll.

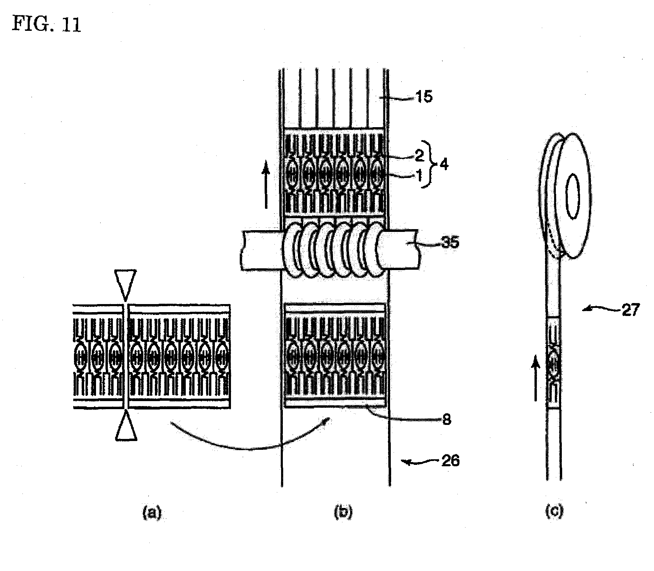

The step 23 comprising: arranging the large-sized inlets on the adhesive face of the tape-based material (15) which is provided or once stopped to provide, wherein the large-sized inlet is arranged in a width direction of the tape-based inlet corresponding to the direction of arranging the inlet elements in a row. Fig.11 shows an example that the direction of transferring a large-sized inlet is at a right angle to the direction of providing an inlet tape-based substrate when a large-sized inlet is arranged on a tape-based substrate which is once stopped to provide. A large-sized inlet adhesive tape is manufactured as shown below: providing predetermined length of tape-based substrate (14), repeating the step 22 and the step 23 again and arranging and fixing a large-sized inlet at a predetermined pitch on the adhesive face of the inlet-based substrate (15).

Furthermore, the step 24 comprising: on the lowest stream to the direction of providing, slitting the tape-based material (15) including a large-sized inlet between pluralities of the inlet elements by the slitter having ring-shaped blades whose number corresponds to that of pitch between the inlet elements arranged in a row on the large-sized inlet.
The step 25 comprising: slitting the tape-based material and respectively winding the inlet adhesive tape on each inlet adhesive tape reel from an edge thereof, wherein the inlet adhesive tape is prepared by arranging the inlets (4) at a predetermined pitch in a longitudinal direction of tape-based substrate (15).
The slitter includes a rotary cutter on both sides of an upper line and a lower line, rotary cutter only on an upper line (single-type rotary cutter), water-jet type cutter, other various apparatus, but not limited to them.
Not only the rotary-type, a platen die cutting type may be employed as an apparatus for boring a hole (11).

In tape-based substrate (15) where a large-sized inlet is arranged, a plurality of tape-based substrate (15) which is preliminary slit may be also employed. Specifically, in the step 21 as described above, a plurality of tape-based substrates are provided as a tape-based substrate and simultaneously unwound from each tape reel, wherein the number of slit tape-based substrate correspond to that of the inlets arranged on the large-sized inlet.

Furthermore, according to the same manner of step 22 and step 23 described above, a large-sized inlet is arranged astride on a plurality of tape-based substrate (15). And according to the step 24 as described above, the slitter slits a large-sized inlet portion of a large-sized inlet adhesive tape. Thus, when a plurality of tape-based substrates (15) is preliminary slit, a positional error is easily caused for positioning a large-sized inlet because a tape-based substrate width is extremely narrow and the number of tape reels increase. However it is possible to simultaneously manufacture the inlet adhesive tapes arranged on the different tape-based substrates on which the inlet elements (104) are arranged the same configuration and size. An inlet adhesive tape may be particularly manufactured efficiently as an inlet adhesive tapes with different tape-based (15) substrates, are respectively required in its small amount.

As described above, the fundamental method of the present invention comprising: preliminary manufacturing a large-sized inlet, attaching a large-sized inlet on the adhesive face of tape-based substrate and manufacturing an inlet adhesive tape as final product by slitting a large-sized inlet. When the inlet adhesive packing material etc... become popular and is consumed in large quantities, the method has an advantage in its manufacturing technique at the stage, compared to the method for manufacturing inlet inclusion goods as shown below. The method comprising: putting a broken line and punching on laminated sheets with exfoliate paper and picking up the label respectively from the sheet. A simple method (an inlet adhesive tape wound on a reel unwound and is mounted on a sheet) has an advantage in quality, reliability and adhesive speed, compared to the method for respectively picking up a label from a tape (film)- wound label with exfoliate paper, which the tape has comparatively wide width.

First, as an inlet manufacturing technology is developing, the inlet size is more and more downsizing regardless of the inlet type classified by communication types. Considering the situation, the inlet adhesive goods have to accommodate the trend of downsizing. Especially, the manufacturing technology (concentrating inlets on a large-sized substrate) is a rational technology in order to accommodate downsizing inlets. Tape-based substrate (15) material may include general-purpose film such as polyethylene terephthalate (PET) film, polypropylene film etc., naturally-derived film, paper etc.... From the viewpoint of environmental conservation, it is preferably to use naturally-derived film such as polylactic resin etc... having biodegradability and a small amount of the exhaust of carbon-dioxide when it is burned.

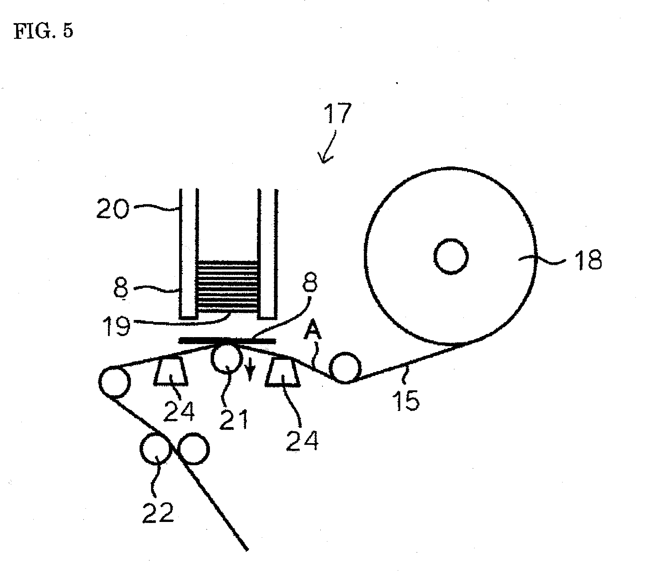

An apparatus with magazines may be utilized as well as the transfer device as described above, when a large-sized inlet is transferred on the adhesive face of the inlet-based substrate (15). As an example, Fig.4 shows the sectional view of partial schematic design of apparatus with a magazine for manufacturing an inlet adhesive tape. Fig.5 shows side elevation view of the apparatus for manufacturing an inlet adhesive tape illustrated in Fig.4.

The apparatus for manufacturing an inlet adhesive tape (17) comprising: a tape-based substrate reel (18), a magazine (20) and pick-up roll (21),
Wherein the tape-based substrate reel (18) winds a tape-based substrate (15) having an adhesive substrate on one face thereof;
Wherein the magazine (20) with an aperture (19) at the bottom loads the large-sized inlets (8) so that the large-sized inlet is retrieve from an aperture; and
Wherein the pick-up roll (21) is arranged opposed to the aperture (19) while providing a tape-based substrate from the tape-based substrate reel between a pick-up roll (21) and the aperture (19). A plurality of rolls (22) is arranged along the direction of providing a tape-based substrate (15). The tape-based substrate (15) is provided between a pick-up roll (21) and the aperture (19), and fixed bars for withdrawing pick-up roll (24) are arranged on the other side of adhesive face (A) of the tape-based substrate in the upper stream and the lower stream along the direction of providing the tape-based substrate (15).

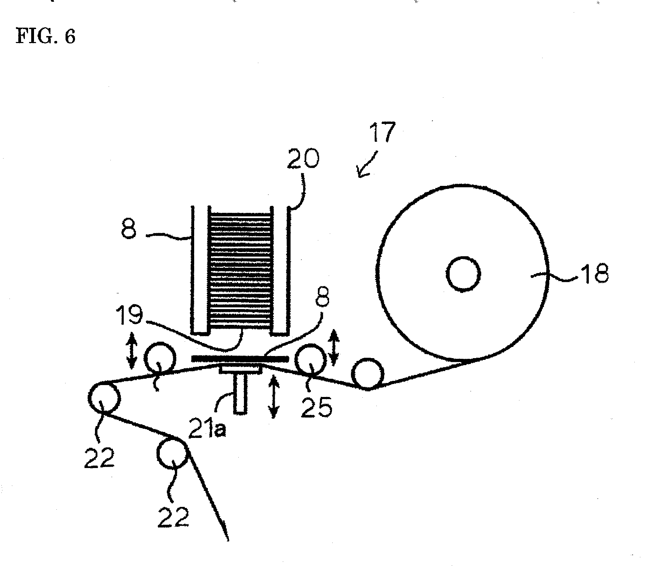

In addition, a pick-up roll (21) may include suction function, or may be used as the arm (21a) illustrated in Fig.6. A silicon etc... is preliminary coated on the surface of the magazine and the pick-up members attaching to the adhesive substrate of the tape-based substrate (15), so that the tape-based substrate can move smoothly.

Furthermore, in the apparatus for manufacturing inlet adhesive tape described above, the process of fixing inlets (4) on tape-based substrate (2) is described below.
Firstly, the step 31 shows that the large-sized inlets are preliminary loaded in the magazine (20).
Instead of preliminary loading large-sized inlets in the magazine, the following process may be applied for its loading. Transferring the large-sized inlets (8) obtained in the step 4 to the upper aperture of the magazine (20) and dropping them therein by a hopper, or piling the large-sized inlets until the weights comes to provide the stable pressure in the magazine so that the large-sized inlets may be withdrawn from the aperture of the magazine, and may be supplied into the magazine by cutting an inlet roll (5).

Then, the step 32 comprising: moving pick-up rolls to the upper position and pressing the adhesive face of tape-based substrate (15) against the large-sized inlet of the aperture (19).
And the step 33 comprising: moving pick-up rolls (21) to lower position, withdrawing the tape-based substrate (15) down from the aperture (19) of the magazine by the tension strength and the suction function of the tape-based substrate (15) and withdrawing a large-sized inlet (8) from the aperture (19) of the magazine, wherein the center of the large-sized inlet is attached to the adhesive face (A) of the tape-based substrate (15).
Preferably, the magazine has a pressure control function, because a large-sized inlet (5) may be easily attached to the adhesive face of the tape-based substrate (15) by a constant pressure thereof.

The step 34 comprising: completely withdrawing the large-sized inlet (8) from the aperture (19) of the magazine, moving the pick-up rolls (21) down to further lower position by canceling suction function, holding the tape-based substrate (15) on the position of the bars (24) and withdrawing tape-based substrate (15) from pick-up roll (21). Furthermore, the step 35 comprising: moving the pick-up rolls (21) to the lowest position so that the pick-up rolls (21) are positioned at regular pitch against the tape-based substrate (15).

The step 36 comprising: providing the large-sized inlets (8) to lower stream along tape-based substrate (15).

The step 37 comprising: pressing the large-sized inlets (8) by a plurality of rolls (22) and attaching the large-sized inlets (8) on the tape-based substrate (15). And step 32 - step 37 are repeated again after tape-based substrate (15) is provided in a predetermined length. The large-sized inlets (8) are arranged and fixed at a predetermined pitch on adhesive face (A) of provided tape-based substrate (15) so that a large-sized inlet adhesive tape is manufactured.

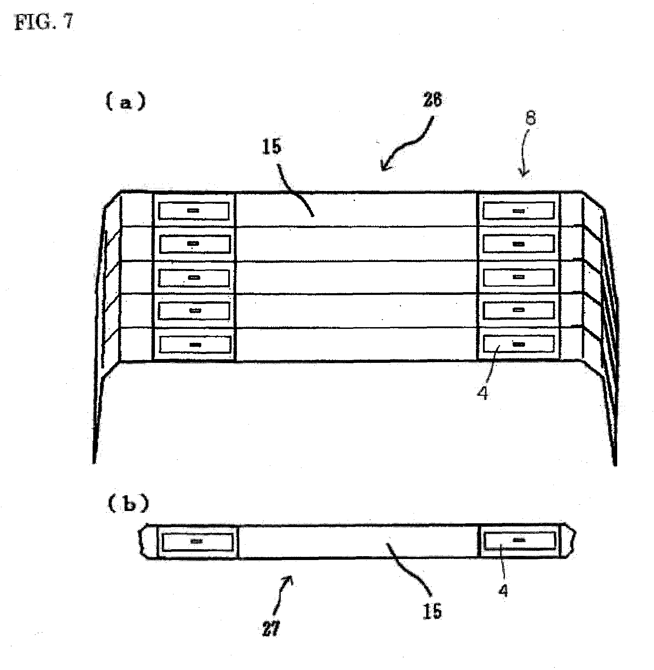

Furthermore, the step 38 comprising: manufacturing a large-sized inlet adhesive tapes as illustrated as Fig.7 (a) and slitting a large-sized inlet adhesive tape (26) along a plurality of slitting-plane lines by a slitter having ring-shaped blades (not illustrated as a figure) whose number is same as that of slitting-plane lines in the lowest stream along the direction of providing tape-based substrate (15).

The step 39 comprising: arranging inlet (4) at a predetermined pitch in a longitudinal direction of tape-based substrate (15) illustrated as Fig.7 (b), and respectively winding the inlet adhesive tapes (27) on each inlet adhesive tape reel from an edge thereof.

Instead of fixed bars for withdrawing pick-up roll (24), Bars (25) for withdrawing a large-sized inlet (8) slid up and down, may be arranged between a pick-up roll (21) and the aperture (19) of the magazine (20) on the other side of adhesive face (A) of the tape-based substrate in the upper stream and the lower stream along the direction of providing the tape-based substrate (15)

In step 32 as described above, bars (25) for withdrawing a large-sized inlet (8) moves up to the position so as not to reach the tape-based substrate (15) when the pick-up roll (21) moves up, or before the pick-up roll moves up.

In step 33 as described above, bars (25) for withdrawing a large-sized inlet (8) move down as the pick-up roll (21) moves down, so that they push tape-based substrate (15) down.

In step 34 as described above, the moderate tension strength of the tape-based substrate (15) moves the tape-based substrate (15) down to a predetermined position and the bars (25) move down until the bars (25) contact with the tape based substrate (15). In this case, as described above, the pick-up rolls (21) move to the lowest position and are set in a regular pitch from tape-based substrate (15).

In addition, when a large-sized inlet (8) is fixed on the adhesive face of the wide width of tape-based substrate an antenna and an IC are arranged between the inlet substrate (5) and the tape-based substrate (15), which provide an advantage for maintaining performance during mechanically handling the tape. It is for this reason that whole thickness of the tape may be thinned as any other guard films are not required. Furthermore, when the arrangement is achieved, it is not required to process a portion of the inlet for its protection, which enables to minimize not only tape thickness, but also the level on the sheet.

As described above, the large-sized inlet (8) is easily withdrawn form the magazine (20) due to the figure and the structure of the large-sized inlet (8). So, an IC chip is positioned roughly in the center of the antenna which is formed by conductive paste or etching for forming metal-film, and an IC chip forms a low projection about 0.2mm on the inlet. Feeding more than two sheets of large-sized inlets may be avoided at the same time, because the large-sized inlets do not stick together by the structure of the inlet portion even when the large-sized inlets are pressed by its own weight in the magazine. Furthermore, a large-sized inlet may be easily and reliably withdrawn from the magazine by moderate rigidity, pliancy and sliding characteristic of film substrate of a large-sized inlet (8). In addition, even when an IC is formed by print method, intricately-shaped of the thin embossment, which is formed on an inlet by conductive paste, is easily withdrawn from the magazine by disturbing to stick inlets together as described above.

In the method for fixing a large-sized inlet on wider width tape-based substrate, when the large-sized inlets are arranged by apparatus for transferring and arranging a large-sized inlet on tape-based material, such as the transfer device with robotic arms as described above, the direction of providing the large-sized inlets may be at right angle and parallel to the direction of tape-based substrate provided.

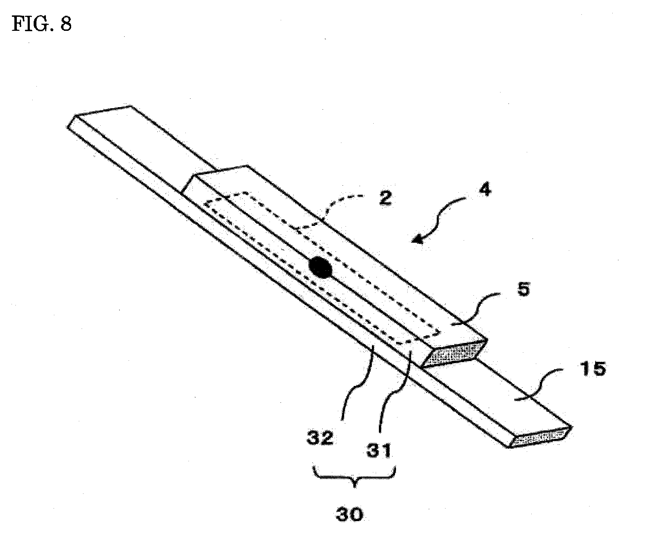

Fig.8 shows a portion of predetermined pitch of an inlet adhesive tape manufactured with the large-sized inlet made by the first method. The inlet (4) includes the inlet substrate (5) on which IC chips (1) and antenna (2) are mounted and is fixed on the tape based substrate to have a predetermined pitch. The inlet adhesive tape (27) set in the predetermined pitch is attached to goods, such as case etc.... In the predetermined pitch of the inlet adhesive tape (27), the inlet is slit to have the cross section surface (30). In the cross section surface, both sides (32) of tape-based substrate along its length completely match to that of the inlet (4) along its length in order to form a flat surface respectively.

Accordingly, as the inlet adhesive tape (27) is attached to a case, an inlet (4) is nipped between case and tape-based substrate (15). However a portion of the inlet is not attached to the case as adhesive substrate is not coated on the surface of the inlet. Applying the large-sized inlet manufactured in the first method, the inlet adhesive tape is attached on paper packing materials. When the materials are recycled as pulp resources at a paper manufacturing plant, it is possible to reduce time for separating string of plastic tape substrate from woody fiber through the maceration such as agitation by means of a pulper at the early stage of the recycle process. The advantage is obtained because a portion of the inlet in an inlet adhesive tape is not attached to the case. So, water is easily penetrated into a portion of the inlet in the inlet adhesive tape by the impact of blades of agitator. When the inlets are removed in the stage of collecting used-papers before throwing them into the agitator, the lower portion of the inlet (not contacting with the material) is cut by means of a sharp apex made from metal, so that the tape may be easily removed.

Furthermore, about the quality of an inlet adhesive tapes as manufactured, the edge of tape-base substrate and the edge of an inlet are attached more strongly with each other by the slit-pressure, so that the cutting edge of adhesive tape have total rigidity in two sheets of films. Therefore, it has an advantage that a portion of its antenna is protected from a stress received in the edge thereof, as high-speed taping machine attaches the tape to sheet-like molded product. Thus, an inlet adhesive tape as manufactured is utilized for attaching to paper packing materials and sheet-like molded products. In the manufacturing process, the inlet adhesive tape unwound from a reel is continuously attached to a sheet cut from its edge to the other. As an inlet adhesive tape is narrow, and has adhesive along its length around the inlet does not contribute to fix the inlet adhesive tape so much. However, without adhesive, the inlet does not influence its adhesion, because an inlet adhesive tape is attached along the entire length of cutting sheet, having comparatively large size and sufficient rigidity. Furthermore, there is no problem of its dropout as the tape is thin.

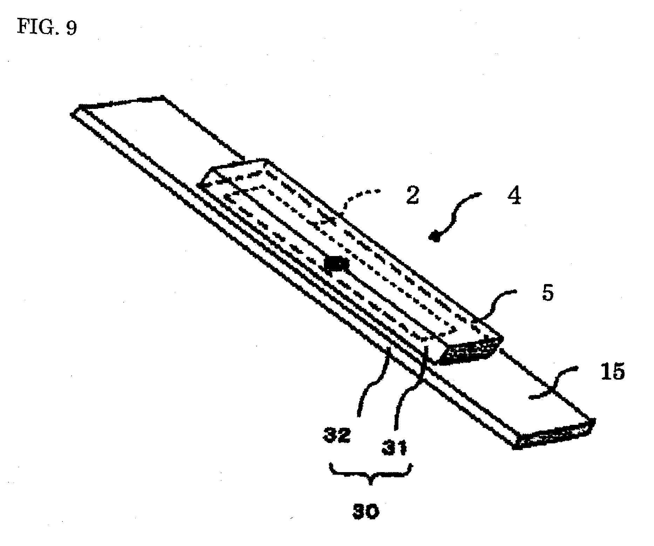

The invention will be described in further details about the method for using the inlet adhesive tape comprising structure as described above. When the inlet width is narrow (about2∼8mm) as illustrated in Fig.8, the margin of the inlet adhesive tape slit becomes small. Thus, as illustrated in Fig.9, it is difficult that each inlet is reliably and exactly attached to the tape substrate at a predetermined pitch. On the inlet adhesive tape, the inlets are attached respectively and wound in a reel. For attaching the inlet adhesive tape to the sheet provided at high speed by taping machine, mechanical impact and friction force are caused when the inlet tape goes through a group of the rollers and the guides in a taping machine, so that inlets may be dropped out from tape substrate.

The inlet adhesive tape has the structure as illustrated in Fig.8. In the process of providing its tape or after attaching to a sheet, when the feed roll adds frictional force on the sheet provided in another processing machine, the adhesion portion is not easily peeled. The adhesion portion is not easily peeled either, when the friction and collision are caused in the inlet adhesive tape exposed on the inside of case while packing operation. The edge portion of cutting the inlet is adhered with that of tape substrate and the rigidity of the edge of the inlet adhesive increase by pilling the edges thereof. A lifting portion is caused in some case when the residual tape substrate is in the side of the inlet portion on the tape substrate, because twist or snaggle of the tape easily causes the sideways force.

When the inlet adhesive tape is manufactured to have narrow width using a large-sized inlet adhesive tape, it is necessary to design inlet adhesive tape without having the pitch between the inlet elements, and to slit a large-sized inlet adhesive tape to divide the inlet elements separately, so that the inlet adhesive tape is manufactured to have the narrow width without having residual side portion in the tape substrate.

At this moment, the present invention will be described about the reason why the inlet elements are arranged on the tape substrate to have the pitch between the inlet elements. For example an inlet element in an IC tag is arranged on the center of IC chip. Around which the inlet element is formed to have an antenna made from conductive element arranged in predetermined figuration and area by the methods of copper corrosion and printing. A plurality of the inlet elements is formed on the inlet substrate. The inlet elements are arranged respectively to have several mm∼30mm intervals between the inlet elements. Thus, int the manufacturing process, the interval is set, IC and antenna may be easily inspected whether they are jointed by sending and receiving signals without interference. The interval provides sufficient residual portion in its tape when described above is beneficial for having sufficient residual portion of its tape as the inlets are fixed in a label by punching. Even if the inlet elements are proximally and accurately arranged in the inlet roll each other. They are cutting mechanically by the slitter etc. for preparing the label. Sufficient margin of tape substrate makes manufacturing loss decrease compared to being cut by strict tolerance specification. In particular, when 1∼2mm is provided between the inlet elements, specially between antennas. An antenna may be damaged while cutting.

In the situation, when the inlets are inspected not at the stage of manufacturing the inlet rolls but at the stage of manufacturing inlet adhesive tape. It is possible to arrange the inlet elements without intervals. If the antenna is formed in zigzag in comparatively bold line or in a rectangle shape, and is set on the both sides of the IC, it is possible to eliminate the boundary line between antennas of the inlet elements as illustrated in Fig. 11 (a).

Thus, when the large-sized inlet adhesive tape is manufactured from the inlet roll, where the inlet elements are arranged, and is slit by slitting apparatus (35) to have a predetermined pitch between the inlet elements illustrated in Fig.11 (b), the area of antennas on the other inlet elements are constant, even if the slit predetermined position slightly swerve to the right or left orthogonally in a longitudinal direction of the inlet adhesive tape. The other side of IC is cut widely when the left side of IC is narrowly cut, so that the area of the slit antenna on the inlet elements is constant, and the performance of antennas may be constantly maintained when a high-performance slitter is used. In addition, it is preferable to coat the antenna surface with a metal, so that a conductive metal thin film on the antenna is not easily broken by slit. It is necessary to control constituent of conductive metal film, in order to get sufficient crushproof of the antenna. According to the apparatus for slitting, the error margin of slitting should be small, preferably should be within 0.5mm. For example, if the position of edge portion of the inlet is constantly scanned by CCD camera and the cutting position of the slitter is corrected, the apparatus for slitting may be controlled within the acceptable error margin of the cutting position and the manufactured tapes have no problem in its quality. As described above, the inlet elements may be arranged on an inlet roll to have zero intervals between the inlet elements in the inlet roll width as well as the inlet roll length. Furthermore, the inlet elements may be arranged to have zero intervals between the inlet elements both direction of the inlet roll. At the situation, when the large-sized inlet is cut, an apparatus is employed to detect the exact position of the edge portion of the inlet and may correct the cutting position of the slitter.

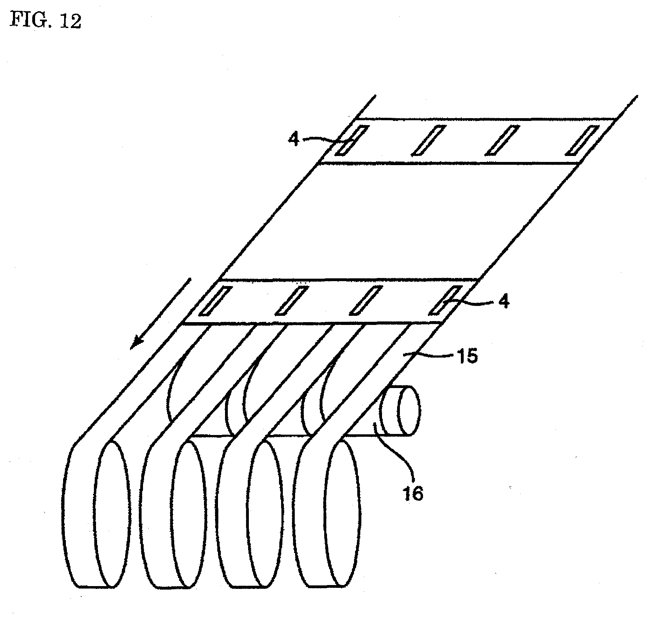

Meanwhile, when the inlet elements are arranged apart on a ready-made inlet roll, the residual tape is removed by the trim method as illustrated in Fig.12 in the process of slitting the large-sized inlet adhesive tape manufactured from the inlet roll. Hereby, the intervals between an antenna on the inlet and the edge portion of the slit tape substrate may be minimized or zero. Thus, it is possible to design the associated parts of the apparatus in a comparatively small size. As a result, the total size may be also designed compactly.

For example, 5∼10m is provided in the width of a ready-made antenna in a tag of UHF-type made by the trim method. 5∼10mm is provided as the width of the inlet adhesive tape when the residual portion of the inlet adhesive tape width is zero. 7∼12mm is provided in the width of the inlet adhesive tape when a residual portion of the inlet adhesive tape width is 1mm. The width of the removed residual portion of the tape is different from each other depending on makers and type of roll, but they are several mm∼30mm range. For example, in the normal label processing, the inlets are nipped between papers having front side and back side and the residual portion of the tape is cut on 2∼3mm around the antenna.

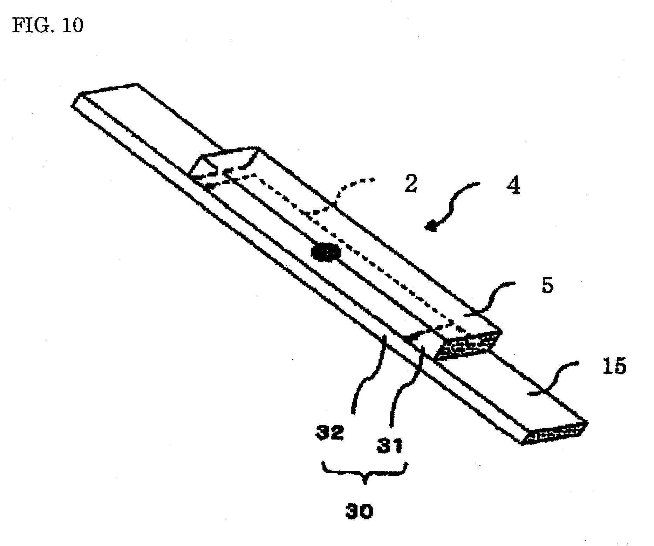

As illustrated in Fig.10 and Fig 11(c), the residual portion is set to zero in the slit of the inlet adhesive tape (27), which may result that the width of the inlet adhesive tape may be narrowed to several mm∼30mm. Hereby, the inlet adhesive tape in the apparatus may be spirally wound on the paper roll of predetermined width, so that a longer inlet adhesive tape may be wound. As the width of the inlet adhesive tape may be narrower, a longer inlet adhesive tape may be wound, so that the apparatus for applying the inlet adhesive tape may be compactly designed.

Furthermore, as an inlet adhesive tape is manufactured to have the narrower width, the tape is easily applied to a sheet or the pitch between sheets, the number of sheets increases. For example, the inlet adhesive tape may be adapted to the tear tape of the plastic wrap of compact-disc (CD). As the inlet adhesive tape with narrow width is utilized, it is possible to reduce the limitation for applying the tape to the goods and the design for packing materials such as case etc.... When the inlet elements are arranged on the inlet roll to have zero intervals between the inlet elements, it is possible to increase the inlet elements arranged on the inlet substrate. Hereby, the film cost of the inlet substrate is reduced. As the shape of the antenna is formed in zigzag in comparatively bold line or a rectangle shape daubed, it is comparatively easy to produce the inlet adhesive tape.

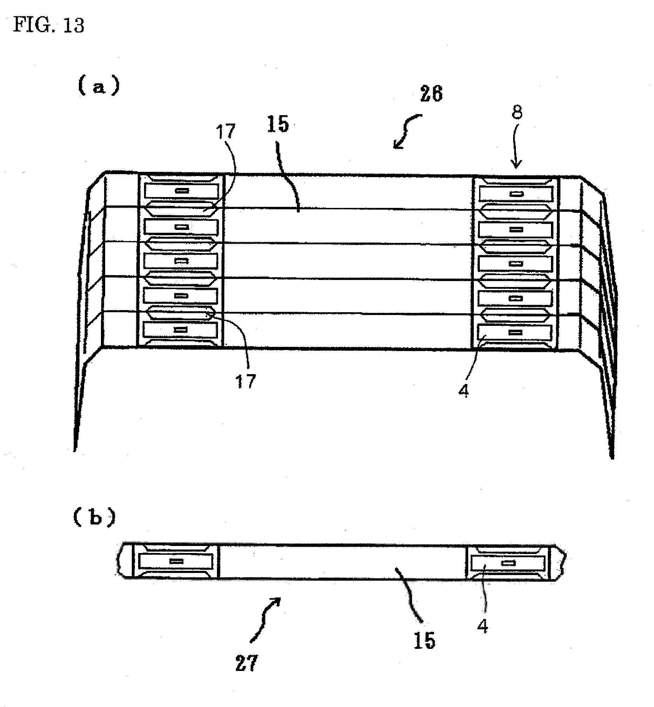

Then, applying the second method, the large-sized inlet adhesive tape is manufactured with a large-sized inlet (8) having holes. The inlet elements are arranged on the inlet adhesive tape in a row. In that case, the large-sized inlet adhesive tape is manufactured as below. Referring to the matter described above, in this case, it is also possible to manufacture the inlet adhesive tape not only in the method and apparatus described in the step 31∼39 but also in the first method described in the step 21∼25. However, the large-sized inlet adhesive tape (26) in the step 38 is illustrated in Fig.13 (a), or the inlet adhesive tape in the step 39 is illustrated in Fig. 13 (b).

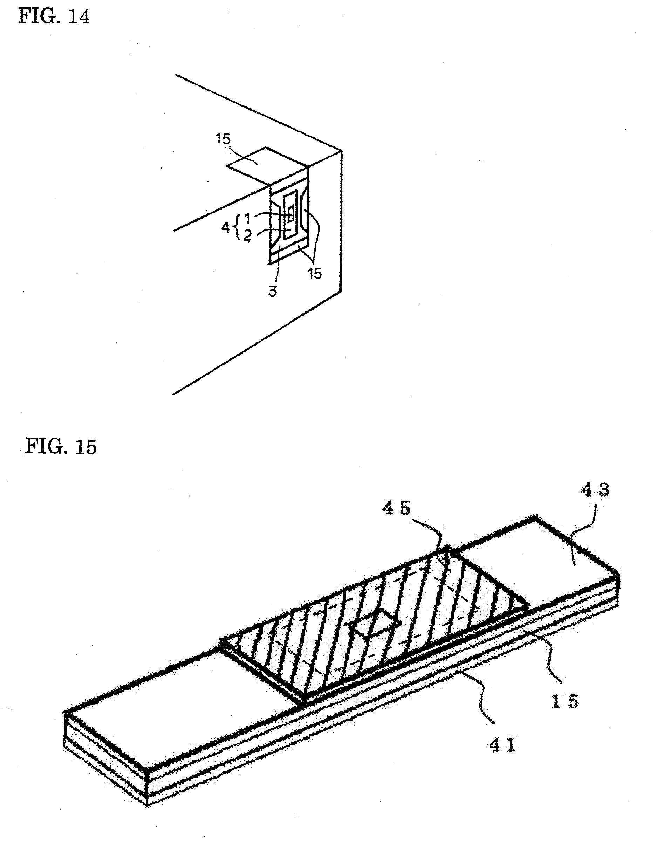

More specifically, a hole (17) is punched inlets between the inlets (4) arranged in a row, so that the large-sized inlet adhesive tape (26) as illustrated in Fig.13 (a) is manufactured. And the large-sized inlet adhesive tape (26) is slit on the position (27) of a plurality of slit-line on tape substrate (15). So the adhesive has been exposed on both sides (31) of tape substrate (15) in a longitudinal direction of inlet (4) in Fig. 13 (b). Accordingly, when the inlet adhesive tape (27) is attached to a case as illustrated in Fig.14, the exposed adhesive portion attaches the inlet substrate (15) to the case at both sides in a width direction of the inlet and length by soft material, which may result that an inlet (4) is held between the case and the tape substrate (15). It is necessary that a large-sized inlet is punched to have the notch (17) with maximum size and sharp, so that the inlet adhesive tape is sufficiently attached at the adhesive portion of the hole. In addition, the inlet (4) portion and the inlet substrate (3) illustrated as full line in Fig.14, are covered with the tape substrate (15). Tape substrate (15) is attached to the case by adhesive portion of the tape substrate (15) indicated by numeral 15 in Fig.14.

When the inlet adhesive tape is manufactured with the large-sized inlet in the second manufacturing method, it is possible to attach the inlet adhesive tape to goods such as case etc... more strongly. as The example of upright apparatus is illustrated to have the tape substrate (15) provided in approximately parallel to the surface of the tape substrate in Fig.4 ∼ Fig.8, but it is also possible to design it as a horizontal apparatus providing tape substrate (15) in approximately vertical to the tape surface.

According to the second method, the inlet portion on an inlet adhesive tape is not absolutely attached to a sheet substrate or a case, so that an inlet portion of the inlet adhesive tape slightly floats. When slit tape-like IC tags are applied to the specific portion of goods or packages at the stage of distribution, the back side of the inlet portion on the inlet adhesive tape is not attached to them. According to the first method, furthermore an inlet portion of the inlet adhesive tape floats when the inlet adhesive tape manufactured by the first method is attached to a sheet on the exposed face of adhesive thereof, because the large-sized inlets are arranged to have a predetermined pitch on a tape substrate where the adhesive is coated, and the inlet adhesive tape is manufactured to have narrow width by slitting the tape substrate. In a slit cross sectional surface (30) illustrated in Fig.10, a little pitch is provided between the inlet portion (4) and a case, which may yield not only the advantage as described above, but also the disadvantage of potential instability factors.

For example, the floating structure may be easily motivated to scratch the inlet portion, and it is possible to peel off the tape substrate portion of an inlet adhesive tape. In addition, when the inlet adhesive tape is shown on the printing surface of packing container, the tape is not probably damaged by the manufacturing apparatus. However, the tape has the problems in the appearance and quality instability while film peeling. Furthermore, when the sheets are extremely-thin papers (processed expense sheet or processed form paper) or flexible plastic bags, it is easy to distinguish the pitch between the inlet and the sheet substrate, so that the instability is caused in handling and selling goods on which the inlet adhesive tape is attached. In addition, the machine troubles may occur when the goods are treated by machines.

For solving the problems described above, it is necessary that the inlet (4) portion is absolutely attached to a sheet or a case. The method includes coating adhesive on the inlet substrate before or after attaching the large-sized inlet to the tape substrate. In the process of attaching the inlet adhesive tapes to the sheet substrate, it is difficult to attach the inlet adhesive tape to the sheet while the adhesion is coated on the inlet adhesive tape having narrow width (specifically 2∼5mm). Therefore, it is preferable to coat the adhesion on the inlet (4) portion before the inlet adhesive tape is slit out. However, the adhesive substrate may be coated on the inlet adhesive tape just before the process of attaching the tape to the sheet. Under the following conditions;
(1) the inlet adhesive tape has the sufficient width;
(2) the apparatus for coating process may exactly coat the adhesive on the inlet substrate in the optimal amount, so as not to run the adhesion off the edge of the inlet adhesive tape after the inlet adhesive tape is attached to the sheet; or
(3) the inlet adhesive tape is placed between the sheets by simple methods.

The method for coating adhesive after attaching a large-sized inlet to the tape is explained as below;
(1) arranging and fixing a large-sized inlet (8) on the tape substrate (15); and
(2) coating the inlet (4) with the adhesive.(the figure of the apparatus for coating is not shown)
   The adhesive or a bonding agent are mainly coated on the large-sized inlet portion. After the large-sized inlet face where the inlet elements are arranged, is arranged and fixed on the adhesive face of the tape substrate, the back side of the large-sized inlet is coated with the adhesive having adhesion in normal temperature or hot-melt adhesive having adhesion by heating. In this case, a nozzle is applied to coat the hot-melt adhesive. For the coating, a non-crush roll formed in special structure is also applied to avoid pressing the IC chip portion which is formed to have some amount of projection for coating. Generally, the adhesive is coated on one face of the large-sized inlet by the method of roll coating, but adhesive may be partially coated for manufacturing a label by the coating method intermittently. The coating amount of ready-made goods of hot-melt adhesive is coated on the ready-made goods in the amount of 8g/cm²∼40g/cm², and coating film has the thickness between 10µm and 30µm. The thickness of coating film is adjusted dependent on the condition of the surface of the sheet where the inlet adhesive tapes are attached. And the adhesive is coated on the ready-made goods to have the thickness of 15µm∼20µm, which indicate the general thickness used in the tape processing.

After the back side face of the large-sized inlet where the inlet elements are not arranged, is arranged and fixed on the adhesive face of the tape substrate, the adhesive having adhesion in normal temperature or hot-melt adhesive is coated on the front side of the large-sized inlet, namely the inlet elements. The film of the coated adhesive may protect the inlets from impact and friction when the inlet adhesive tapes are attached to the sheets. When the inlet adhesive tape is attached to the sheet material such as case, the inlet elements are placed between two plastic films (the tape substrate, the inlet substrate) and the sheet material, so that the inlet elements are protected from the external impact force. Finally, in this case, the inlet elements may be highly protected by buffer packing.

Another method for coating the adhesive to the inlet substrate is used for preliminarily coating the adhesive on the back side face of the large-sized inlet on which the inlet elements are not arranged. The adhesive without expressing adhesion is adopted when a large-sized inlet is arranged on the tape substrate. A hot-melt type adhesive loses adhesion by cooling. Thus, this adhesive may be adapted to the method described above. In another adhesive, the type of rewetting adhesive such as polyvinyl alcohol may be utilized for preliminarily coating and drying the adhesive, if a water-based adhesive may be utilized for treating the surface of the plastic inlet substrate.

It is not especially limited when the adhesive is coated on the back side of the inlet substrate, but should be coated before the large-sized inlets are cut out. For example, the adhesive may be coated on the inlet substrate before each slit inlet roll is wound in a roll as described in step 3. Furthermore, the adhesive may be coated on the back side of the inlet substrate (3) before the inlet elements (104) are arranged on the inlet substrate. The method for coating hot-melt adhesive on the inlet substrate includes roll coating or extrusion coating.

In the hot-melt method, the component of resin and wax is generally melt between 150 and 180 degrees Celsius and the adhesive is uniformly coated on the face in the roll coating method. It is possible to use the two types of adhesives, which are low melting point type about 60 ∼ 90 degrees Celsius and at intermediate melting point type. The inlet adhesive tape where the hot-melt adhesive is coated is heated and attached to the sheet substrate. It has an advantage for productivity, when the hot melt adhesive melt at lower temperature is used. For example, when a heating process is utilized in manufacturing a normal cardboard and a plastic cardboard, a belt etc...the presses inlet portion having hot melt adhesive on the a sheet face exposed in a high temperatures, so that the adhesive on the tape substrate is attached to the cardboards around the inlets and hot melt adhesive on the inlet substrate is attached to the cardboards at the same time. Therefore, it has an advantage for its productivity, when the hot melt adhesive melts and has adhesion without heat reservoir.

Thus, the adhesive is coated on the back side face of a large-sized inlet by the coating method, after a large-sized inlet is fixed. Or the adhesive is coated on the back side face of a large-sized inlet by the method for coating the adhesive on the inlet substrate. The inlet elements on the large-sized inlet are arranged and fixed on the tape substrate. These tape substrates are slit and the inlet adhesive tape is manufactured. The adhesive is coated on the inlet (4) of the inlet adhesive tape. An adhesive layer is formed on the whole surface of the tape. In this case, it reduces the risk that an IC tag peels off. When the IC tag of UHF type antenna is used for distribution, the tape width is especially set to 2∼5 mm and the antenna is also set to be long. Finally, it will resolve the shipping problem and quality problem.

Compared to the manufacturing method for forming the inlets by punching respectively, it is more preferable to load the large-sized inlets (8) in the magazine. Therefore, it has an advantage in efficiency and cost. Thus, the tape substrate (15) corresponding to the large-sized inlet (8) has wide width. Accordingly, after a large-sized inlet adhesive tape is wound in order to stably fix the large-sized inlet (8) on the adhesive face of the tape, the inlet reels may be manufactured by the slit inlet adhesive tape. Especially, when the minimized the inlets are used, the inlet reels may be efficiently manufactured for maintaining the quality. And the inlet adhesive tape having minimized width may be efficiently used as industrial material by utilizing the developing technology.

As mentioned above, the inlet is arranged on one side of the adhesive face of the tape substrate in order to attach to a sheet or a case. Furthermore, the method for coating the adhesive is described in the above. Then, the usage of the tape substrate with the adhesive on both sides thereof is described below. The tape substrate is not attached to the face of a sheet when the machine is on or off. The tape substrate may be used when an inlet adhesive tape is placed between two sheets or between members. After a hot melt adhesive layer is formed on the both sides of the tape substrate, the tape substrate is cooled and wound in a reel. This hot melt adhesive has the grades of hot-melt adhesive melting at general temperature. In this case, the tape substrate may be utilized when the tape substrate wound on a reel has a low adhesion. It is necessary to adjust the adhesion of the substrate by combining or coating antiblocking agents when the tape substrate have a high adhesion.

One face of the tape substrate where a large-sized inlet is attached is coated with hot-melt adhesive having a low melting point. The opposite face of the tape substrate is coated by hot-melt adhesive having melting point higher than the low melting point. In this structure described above, when the large-sized inlet is applied on the tape-based substrate after unwinding the tape-based substrate, adhesive face on the large-sized inlet may be turned moderate condition of the adhesion having low melting point by guiding the tape-based substrate into constant-temperature reservoir or dielectric heater is set at the condition of the low melting point. In this case, exfoliating treatment is not provided on both sides of the tape substrate.

The large-sized inlet adhesive tape is slit. The inlet adhesive tape without having adhesion at normal temperature is placed between two sheets and the inlet adhesive tape is fixed between the two sheets by heating at high melting point. Thus, the inlet adhesive tape having the hot-melt adhesive on both sides thereof is connected to the two sheets by the hot-melt adhesive so as to have a similar effect of double-stick tape. The inlet adhesive tape is sufficiently attached to the sheets.

The inlets adhesive tape manufactured as described above may be wound like in a reel without exfoliate paper. As the blocking occurs between two kinds of hot melt adhesives due to the condition of storage, of exfoliate substrate is mixed to hot-melt adhesive on one side of coating layer in the optimal quantity, unless the adhesion of hot-melt substrate are inhibited. The exfoliate substrate is selected and mixed to hot-melt adhesive on one side face of coating layer in optimal kinds unless the adhesion of hot-melt substrate are inhibited.

The inlet adhesive tape has a hot-melt adhesive coating on both sides as described above. When the tape is heated at low melting point, it is possible to provide a moderate adhesion on one face of the inlet adhesive tape. Thus, the inlet adhesive is treated to have general adhesion coated on the inlet adhesive tape. And then, the inlet adhesive tape may be treated with the second heating process in order to attach completely. The tapes have an advantage to position them easily even when the machine is on or off.

When the inlet adhesive tape is manufactured with the large-sized inlets to have adhesive on both sides, it is possible to simplify the process for coating adhesive or hot-melt adhesive in the automation of book binding. In general, the adhesive is coated on a predetermined position on the back side of a book cover. Sealed inlets are respectively withdrawn from a magazine and attached on the back side of a book cover, or IC labels are picked up from a label adhesive sheet along cutting-plane line respectively and attached on the back side of a book cover. Furthermore, the back side of the book cover is coated with the adhesive again and is attached on the back cover of a body text quire. When the inlet adhesive tape is used, the process may be simplified. First, two kinds of hot-melt adhesive are preliminarily coated on both sides of the inlet adhesive tape, and the inlet adhesive tape may be easily adapted to the processing speed of the book binding process. The inlet adhesive tape is unwound, and then may be attached to the book, when the adhesive is adjusted to have the optimal heating temperature of the adhesive, so that it is possible to attach the inlets to the back cover of the book. Thus, it is not necessary to rebuild the book bidding process in a long line, when several kinds of apparatus are installed.

When the inlet adhesive tape is manufactured to have the hot melt adhesive on both sides, the inlet adhesive tape illustrated as Fig.15 may be completely attached between two papers, sheets or clothes etc... if the hot-melt adhesive is coated on the exposed face of the inlet substrate in the inlet portion as described above. The tape substrate (15) has a hot-melt adhesive layer with low melting point (43) and in the opposite sides thereof have a hot-melt adhesive layer with high melting point (41). The hot-melt adhesive layer (45) is also provided on the inlet substrate. The hot-melt adhesive on the exposed portion of this inlet substrate may be utilized regardless of low or high melting point type.

The effect for positioning the inlets is provided, when the hot melt adhesive is coated on the both sides of the tape substrate as described above. On the other hand, combination process may be provided to linearly coat an adhesive on the face of the inlet substrate having low melting point. The effect for positioning and holding the inlets may be provided, when the inlet substrate has the adhesive face in low melting point. In this case, it is necessary that the inlet adhesive tape has sufficient width in order to coat the adhesives on the tape substrate respectively when the tape substrate width is divided into two or three parts. It is deniable to prepare the processed tape to have more than about 10mm width. For example, if the tape width is 10mm, the adhesive and hot-melt adhesive are adjacently coated on the inlet tapes in the tape width (10mm) respectively, and the tape is slit at the centre position of the range of the inlet tape, so that the inlet adhesive tape include two adhesive. Finally, the tape has the adhesion and the hot-melt adhesive with low melting point. Considering the blocking condition occurred when the tape is wound, it is preferable to select the adhesive with a weak adhesion.

When two kinds of adhesives are mixed with hot-melt adhesive to have a low melting point, the similar effect for positioning inlets may be provided. In this case, the tape may be maintained a configuration of reel, when the tape is attached by itself due to the effect of adhesive while the tape is wound on a reel. The hot-melt adhesive starts melting by heating, so that the adhesive deeply penetrates through the pores of the sheet and the two sheet or two material are fixed As adhesive face of the tape, on which hot-melt adhesive is coated, melts and is attached to the sheet if the surface of the sheet is rough and meshes structure have a lot of pores.

Furthermore, it is possible to use IC tags (inlet) in the following situation; inserting the IC tags between layers of a collar stay material of a work uniform or high-grade apparel, or turnover of the clothes, fixing the IC tags to the interior portion of shoes materials or buildup material, and using an adhesive for laminate as formed electric parts. When the hot-melt adhesive is double coated on the inlet adhesive tape, it is possible to surely fix the inlet adhesive tape between two materials under the following steps; withdrawing the tape used as described above, the tape with an inlet is cut as the inlet does not damage after the tape is unwound from a reel, and then the tape is temporarily jointed at the position and may be efficiently attached between two materials by iron heating or press.

For the ID purposes, it is possible to easily attach the IC tags (inlet) on the cards such as such as IC card of cash card, IC passport, IC driver's license, company ID card etc.... The IC tags cannot be separated and peeled off after the inlet adhesive tape where the adhesive is double coated, is installed and laminated with double faced films.

### Industrial Applicability

The present invention may be preferably utilized to the apparatus for attaching the inlets, on which digital information is recorded, to a packing case. Or the inlet may be preferably utilized to attaching the two sheets.

### BRIEF DESCRIPTION OF THE DRAWINGS

- Fig.1: is a diagrammatic framework showing an example of a large-sized inlet, according to the method for manufacturing a large-sized inlet in the present invention.
- Fig.2 (a): is another example of showing the arrangement of inlet elements on the large-sized inlet.
- Fig.2 (b): is another example of showing the arrangement of the inlet elements on the large-sized inlet.
- Fig.3: is a constitution view showing punching between inlet elements on an inlet roll by means of the apparatus for punching a film.
- Fig.4: is a cross sectional view showing an example of diagrammatic framework of a portion of an apparatus for manufacturing an inlet adhesive tape.
- Fig.5: is a side elevational view showing an apparatus for manufacturing an inlet adhesive tape in fig.4.
- Fig.6: is a side elevational view showing another example of an apparatus for manufacturing an inlet adhesive tape.
- Fig.7: is a view of the tape manufactured in the first method. (a) shows large-sized inlet and (b) shows inlet adhesive tape.
- Fig.8: is a view showing predetermined pitch of inlet adhesive tape manufactured with large-sized inlet by the first method.
- Fig.9: is a view showing predetermined pitch of inlet adhesive tape formed by transferring and applying an inlet on the tape substrate. A side portion in a longitudinal direction of inlet corresponds to a tape substrate.
- Fig.10: is a view showing predetermined pitch of inlet adhesive tape that is slit and formed from large-sized inlet to have zero intervals between inlets. A tape substrate and an inlet substrate are piled in two layers in a longitudinal direction of inlet.
- Fig.11: is a view of the process for manufacturing an inlet adhesive tape. (a) shows the process of cutting out a large-sized inlet from inlet roll, (b) shows the process of slitting a large-sized inlet adhesive tape, and (c) shows the process of forming inlet adhesive tape by slitting.
- Fig.12: is a constitution view showing slitting a large-sized inlet by trim method.
- Fig.13: is a view of the tape manufactured with a large-sized inlet by the second method. (a) shows a large-sized inlet and (b) shows inlet adhesive tape.
- Fig.14: is an enlarged partial view showing that the inlet adhesive tape in Fig. 11 (b) is attached to a case in a predetermined interval.
- Fig. 15: is a view showing predetermined interval portion of inlet adhesive tape manufactured by attaching a large-sized inlet on a tape substrate, both of which is coated with hot-melt adhesive.

### EXPLANNATION OF REFERENCE NUMERALS

- 1.: IC chip
- 2.: antenna
- 3.: inlet substrate
- 4.: inlet roll
- 5.: slitting-line
- 6.: cutting-line
- 104.: inlet element

## Claims

1. A method for manufacturing a large-sized inlet comprising:
arranging inlet elements on an inlet substrate unwound from an inlet roll in column to have a predetermined pitch in a width direction of a inlet roll and in parallel to have a predetermined pitch in a longitudinal direction of a inlet roll, and
cutting the tape based substrate at every predetermined number of inlet elements arranged in parallel in a longitudinal direction of the inlet roll 1 on inlet roll where the inlet elements are arranged in column and parallel.

2. The method for manufacturing the large-sized inlet according to Claim 1, further comprising:
slitting up the pitch between inlet elements from the edge of inlet roll which arranges the inlet element in a width direction of the inlet roll after arranging inlet elements in column and
parallel on the inlet substrate and,
wherein in the process for manufacturing the large-sized inlet, the slit inlet roll is cut at every predetermined number of inlet elements arranged in parallel in a longitudinal direction of the inlet roll in the process for manufacturing the large-sized inlet.

3. The method for manufacturing the large-sized inlet according to Claim 1 or Claim 2, comprising:
boring a hole between inlet elements in a longitudinal direction of the inlet roll after arranging inlet elements in column and parallel on the inlet substrate.

4. The method for manufacturing the large-sized inlet according to Claim 1 or Claim 2,
wherein the adhesive substrate is preliminary coated on the back side of the inlet roll where the inlet element is not arranged, before arranging the inlet elements.

5. The method for manufacturing the large-sized inlet according to Claim 1 or Claim 2,
wherein in the step of arranging, the inlet element is arranged to have zero interval as a predetermined pitch in parallel in a longitudinal direction of the inlet roll, the inlet roll width, or both directions in the process of arranging.

6. On an adhesive face of tape-based substrate, a inlet adhesive tape, manufactured through a step of attaching a large-sized inlet which is formed to have a plurality of the inlet elements arranged in a row on inlet substrate,
wherein the large-sized inlet is attached on the tape-based substrate to have a predetermined pitch in a width direction of the inlet-based substrate corresponding to the direction of arranging the inlet elements in a row,
wherein the large-sized inlet is slit to go through a pitch between a plurality of inlet elements in a longitudinal direction of the tape-based substrate,
wherein the tape-based substrate with the large-sized inlets is slit in a longitudinal direction of the tape-based substrate,
wherein the inlet is arranged in a row to have a predetermined pitch on each slit tape-based substrate.

7. The inlet adhesive tape according to Claim 6, wherein an adhesive substrate on the other face of the adhesive substrate has a higher melting point than that on the adhesive face.

8. The inlet adhesive tape according to Claim 6 or Claim 7, wherein a plurality of the inlet elements are arranged adjacently on the large-sized inlet.

9. The inlet adhesive tape according to Claim 6 or Claim 7,
wherein in the step of attaching the large-sized inlet on the tape based substrate and attaching the inlet adhesive tape on a sheet, the adhesive substrate is coated on the exposed face of the large-sized inlet.

10. The inlet adhesive tape according to Claim 6 or Claim 7, wherein the adhesive substrate is preliminarily coated on the back side of the large-sized inlet where the inlet elements are not arranged,
wherein the front side of large-sized inlet is attached on the tape-based substrate,
wherein the adhesive substrate on the back side thereof melts by heating when the inlet adhesive tape is attached to goods.

11. The inlet adhesive tape according to Claim 6 or Claim 7,
wherein the inlet substrate has notch portion on at least one face of the slit inlet around inlets attached on the tape-based substrate.

12. The inlet adhesive tape according to Claim 6 or Claim 9,
wherein the inlet element mounted on the inlet substrate, is arranged between the adhesive face of the tape-based substrate and the inlet substrate.

13. The inlet adhesive tape according to Claim 6 or Claim 7,
wherein the tape-based substrate is cut on both edges of the inlets in a longitudinal direction of the tape-based substrate when the tape-based substrate and the large-sized inlet are slit in a longitudinal direction of the tape-based substrate.

14. The method for manufacturing the inlet adhesive tape, comprising;
providing the tape-based substrate by providing the tape-base substrate from a reel winding the tape-based substrate of which adhesive substrate is coated on one face,
arranging a large-sized inlet where a plurality of inlet elements are arranged in a row, on the adhesive face thereof to have a predetermined pitch in a width direction of tape-based substrate corresponding to the direction of arranging the inlet elements in a row,
slitting the tape-based substrate with the large-sized inlet to go through the pitch between a plurality of inlet elements arranged on the large-sized inlet in a row,
winding each inlet adhesive tapes with inlets is arranged in a row separately to have a predetermined pitch after slitting.

15. The method for manufacturing the inlet adhesive tape according to Claim 14, comprising;
coating adhesive substrate which has a higher melting point than that on the adhesive face, on the other face (the second adhesive face) of the adhesive face of the tape-based material before providing the tape-based substrate.

16. The method for manufacturing the inlet adhesive tape according to Claim 14 or Claim 15 further comprising;
coating the adhesive on the exposed face of the large-sized inlet after arranging the large-sized inlet.

17. The method for manufacturing the inlet adhesive tape according to Claim 14 or Claim 15, wherein the adhesive substrate is preliminarily coated on the back side of the large-sized inlet, on which the inlet elements are not arranged.

18. The method for manufacturing the inlet adhesive tape according to Claim 14 or Claim 15, wherein in the step of slitting, the inlet adhesive tape is slit on both edges of the inlets in a longitudinal direction of the tape-based substrate, so that the extra pitch of the tape-based substrate is removed.

19. An apparatus for manufacturing the inlet adhesive tape arranging inlets on the adhesive face of the tape-based substrate, comprising;
a tape-based substrate reel winding the tape-based substrate where an adhesive substrate is coated on one face thereof,
a magazine where the large-sized inlets arranging a plurality of the inlet elements in a row are loaded and retrieving the large-sized inlet from an aperture of it,
a pick-up member opposed to the aperture which the tape-based substrate goes through between them, and wherein the tape based substrate is provided by unwinding the tape-based material wound on the reel or halted the process temporarily,
a slitter for slitting the large-sized inlet to have the pitch between the inlet elements arranged on the tape-based substrate in a row,
a plurality of reels for winding each inlet adhesive tapes separately on which inlets slit by the slitter are arranged to have a predetermined pitch in a row,
wherein the adhesive face of the tape-based substrate is pressed against the large-sized inlet on which the aperture is arranged when at least one of the magazine or the pick-up member approaches toward the other, and then, the large-sized inlet including the aperture is unwound from the magazine when at least one of the magazine or the pick-up member gets away from the other.

20. The apparatus for manufacturing the inlet adhesive tape according to Claim 19, wherein an adhesive substrate on the other face of the adhesive face has a higher melting point than that on the adhesive face.

21. The apparatus for manufacturing the inlet adhesive tape according to Claim 19 or Claim 20,
wherein the pick-up member includes an arm and a roll having reciprocating motion, and is arranged opposed to the aperture and is arranged in the upper stream and the lower stream of the tape based substrate placed between the pick-up member and the aperture along the direction of providing tape-based substrate,
wherein a bar for unwinding large-sized inlet is arranged on the adhesive face of the tape-based material, and follows the direction where the pick-up member displaces, so that the tape substrate is withdrawn from the aperture.

22. The apparatus for manufacturing the inlet adhesive tape according to Claim 19 or Claim 20,
wherein a bar for the pick-up member arranges to the non-adhesive face side of the tape-based substrate and is arranged opposed to the aperture and is arranged in the upper stream and the lower stream of the tape based substrate placed between the pick-up member and the aperture along the direction of providing tape-based substrate,
wherein the bar for the pick-up member arranges to the other face of the adhesive face of the tape-based substrate and catch the tape-based material as the tape-based material is pressed down by suction of the pick-up member.
